# EUROPEAN PATENT SPECIFICATION

(11) **EP 1 424 564 B1**
(45) Date of publication and mention of the grant of the patent: **17.08.2005**
(21) Application number: 02400053.1
(22) Date of filing: 28.11.2002
(51) Int. Cl.: G01R 31/28

(54) **Method for defining a version of an electrical appliance**
Verfahren zum Definieren einer Version für ein elektrisches Gerät
Méthode pour définir la version d'un appareil électrique

(43) Date of publication of application: 02.06.2004
(73) Proprietor: E.G.O. Control Systems GmbH, 72336 Balingen-Frommern (DE)
(72) Inventor: Manan, Pep, 08125 Montacadai (ES); Soler, Marc, 08021 Barcelona (ES); Badia, Carme, 08190 Sant Cugat (ES); Torres Sanchez, Antonio, 08520 Les Franqueses (ES); Alvarez, Jordi, 08150 Parets del valles (ES); Gamiz, Francesc, 08031 Barcelona (ES); Agenjo Sauceda, Juan Carlos, 08303 Mataro (ES); Castane Castro, Nuria, 08100 Mollet d. Valles (ES); Travé Ramis, Anna, 08520 Les Franqueses (ES)
(74) Representative: Patentanwälte Ruff, Wilhelm, Beier, Dauster & Partner

(56) References cited:
- EP-A- 0 550 263
- US-A- 4 703 306

## Description

### Technical field of the invention

The invention relates to a method for defining a version of an electrical appliance as a machine setup.

Usually an electrical appliance, for example a washing machine, has to be tested after manufacturing. In some cases, the machine setup regarding functionality or the like, has to be done before testing. For this, on one hand storage means can be inserted into control means of the electrical appliance, wherein the storage means contain the information for the machine setup and as such for the functionality. On the other hand, as this is usually seen as a big effort after the process of manufacturing of the appliance, the defining of the version or the functionality of the appliance can be done by programming the control means or electronic storage means contained in the control means. Such a programming can be performed by using combinations of the user buttons of the control means. On the other hand, a programming interface can be provided on the control means for connecting to a setup device or programming device.

After the process of defining the machine setup, the appliance is tested according to its defined functionality before shipping to customers.

### Problem and solution

The problem underlying the invention is to provide a method for defining a version of an electrical appliance as a machine setup, wherein the method allows for easier machine setup and easier testing of an electrical appliance after manufacturing and before shipping.

This problem is solved by a method with the features of claim 1. Preferred and advantageous embodiments of the invention are contained in the further claims and described hereinafter in greater detail. The wording of the claims is incorporated into the description by explicit reference thereto.

The document EP 0 550 263 relates to a diagnostic adaptor module for a domestic appliance.

According to the invention, in the method described hereinafter the desired version of the appliance is defined regarding its functionality, for example the turning speeds, different washing programs or characteristics for a washing machine which are specific to a particular country where the appliance is to be shipped. The appliance has control means with an electronic storage means contained therein, a power supply and a main cable for the power supply. The electronic storage means are capable of containing the information for defining the functionality of the appliance for the machine setup. For storing the information or the machine setup into the electronic storage means the appliance is connected to a setup and test device by means of the main cable. The information with the machine setup is transmitted from the setup and test device to the appliance via the main cable. By this it is possible to connect the appliance only once to any other device, namely the setup and test device. Via the main cable not only the power for testing the appliance is supplied. Furthermore, the information with the machine setup is also supplied or transmitted to the appliance and is stored into the electronic storage means. So only one process of connecting the appliance after manufacturing and before shipping is necessary for the setup and the test of the appliance. Furthermore, no further cables, connections or interfaces as additional hardware are needed.

The information containing the machine setup can be encoded in the setup and test device. This has the advantage, that the signal to be transmitted can be simpler and need not contain every detail of the information about the machine setup but for example only a short information like "version 3". In the control means a decoding of the transmitted information, which is received through the main cable, can be done. The control means can read the information as "version 3" and store the whole machine setup according to the definition of "version 3" into the storage means. Another possibility would be to store machine setup information for several versions of the appliance into the electronic storage means and to choose one of the versions by the control means after receiving the information from the setup and test device.

One possibility for transmitting the information for the machine setup is a modulation of the information in the setup and test device into a specific signal. Only the signal has to be transmitted via the main cable.

The information may also be modulated onto the voltage for powering the appliance. This means, that after connecting the main cable of the appliance to the setup and test device the appliance may be powered. After powering the information maybe transmitted from the setup and test device to the appliance and the machine setup may be stored into the electronic storage means. The modulation preferably is a frequency modulation. It is modulated onto the usual power frequency of fifty or sixty Hz. A frequency modulation of the information is preferably done with two different frequencies. It may be on one hand a digital way with a lower frequency and a higher frequency. In this case, a lower frequency can have the meaning of logical zero and a higher frequency can have the meaning of logical one. In this case, the frequencies can be transmitted for a fixed time, for example about one second. In this way, a binary encoded information can be transmitted consisting of zeros and ones. This information means a certain number, for example 00101 means "version 5".

On the other hand, a certain frequency can in itself contain the information for a specific version of the appliance regarding the machine setup. For example, a frequency of 75 Hz modulated onto the main cable can have the meaning of 00110 and as such "version 6".

Information for the machine setup can define functionalities of the appliance or influence them. For example, by defining the machine setup a given model series of the appliance is defined. Furthermore, touch control buttons or programs of the control means or ways of displaying information can be defined in the machine setup.

According to the above mentioned details, the information for the machine setup is already contained in the setup and test device. For defining this information regarding a specific electrical appliance being connected to the setup and test device has to be provided. The information can preferably be given with this specific appliance. It is possible, for example, to provide an optical identification marking on the appliance. This optical identification marking can be read and analysed as well as transmitted to the setup and test device. The setup and test device produces the information for the machine setup from the identification marking, transforms this information into a signal or the like for transmitting it to the appliance via the main cable, as has been described above.

The reading of the optical identification marking can preferably be done by a machine or by a computer. According to one possibility, the optical identification marking can be a barcode. A usual barcode reader can be provided to recognize the information from the barcode and transmit this information to the setup and test device. This transmitting of information can be done by radio frequency transmission.

Furthermore, it is possible to display information according to the machine setup or according to the optical identification marking of the appliance. It can be displayed on the display means of the control means of the appliance. This has the advantage, that a person supervising the setup and test of the appliance can recognize the version of the appliance and check if a testing and setup is successful.

These and further features can be taken from the claims, description and drawings and the individual features described wherein. This can both be singly or in subcombinations be implemented in an embodiment of the invention and in other fields. They can represent advantages, independently protectable constructions for which protection is hereby claimed. The subdivision of the application into individual sections and subtitles does in no way limit the general validity of the statements made thereunder.

### Short description of the drawing

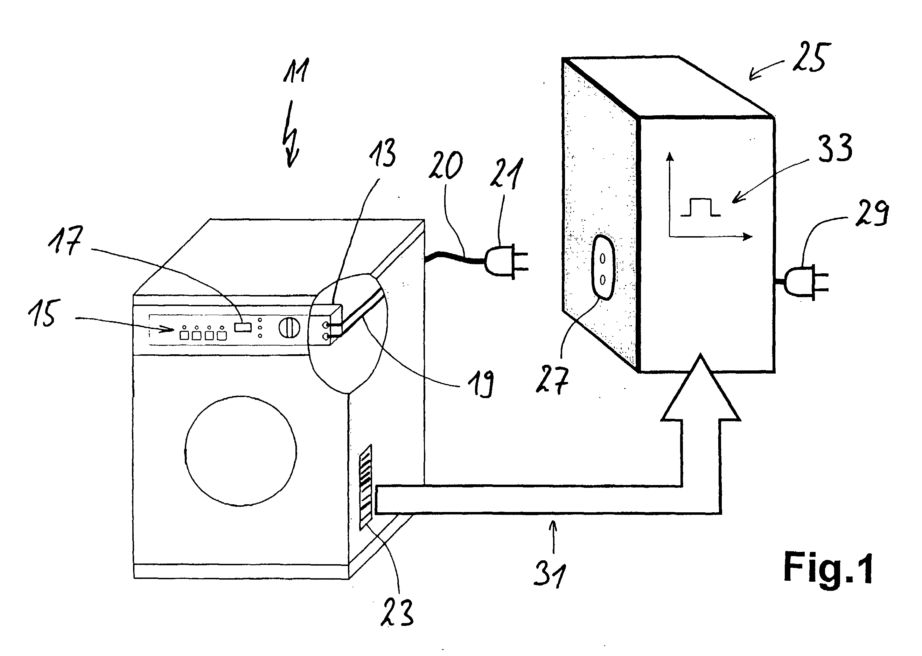

An exemplary method according to the invention is schematically shown in the figure and is described hereinafter. In Figure 1 a washing machine is shown after manufacturing which is to be connected to a setup and test device.

### Detailed description of the embodiment

In figure 1, a washing machine 11 is shown. The washing machine 11 has control means 13 built in it. The control means comprise electronic devices such as a micro-controller or the like and electronic storage means. The electronic storage means may be an EEPROM. The control means 13 further comprise touch buttons 15 and a display 17 for a user of the washing machine 11.

Via connector lines 19 the control means 13 are connected to an AC main cable 20. This connection may be incorporated in a power supply unit in the washing machine 11. Between the control means 13 and the AC main cable 20 with the plug connector 21 fuses for switching devices may be provided. This serves as security means for the washing machine 11 or, especially, the control means 13.

The washing machine 11 as shown in figure 1 is in a state direct after manufacturing and before a setup and test of the machine. In the setup usually the functionalities of the appliance or the washing machine 11 are defined. That is, in the control means 13 or the electronic storage means data and parameters are stored. They define for example functionalities of the touch buttons 15 or the display 17. Furthermore, if the display 17 can show words or the like for a user, those words are stored into the control means 13 during setup of the machine 11.

In a test procedure, usually a machine is tested as to its functionalities. This testing is usually done by a test device. After that, the machine is ready for shipping

As is shown in figure 1, the washing machine 11 is connected via the AC main cable and the plug connector 21 to a setup and test device 25. The device 25 has a connector socket 27 for the plug connector 21. This is the only connection needed between the washing machine 11 and the setup and test device 25. The device 25 itself has its own main cable 29 for power supply.

On the side of the washing machine 11 a barcode 23 is fixed. This can be by means of a sticker or the like.

An information transfer 31 from the barcode 23 to the setup and test device 25 is shown. This information transfer 31 is shown in a schematic way. It is of course to be understood that it can be in variable form. On one hand, it could be a machine reading and optical analysing of the barcode 23 with a transfer of the information from the barcode to the setup and test device 25. Furthermore, an information transfer 31 from the washing machine 11 to the device 25 could be done by human input into the device 25. Furthermore, other ways of providing the setup information for the machine 11 to the device 25 can be provided.

In the setup and test device 25 the information from the barcode 23, which defines the functionalities that the washing machine 11 should have, is transformed into a frequency-modulated signal 33. As such is easy to realize for anybody skilled in the art, such a transforming need not be described in further detail. The frequency-modulated signal 33 is described only in a schematic way.

The frequency modulated signal 33 is transmitted via the connector socket 27, the plug connector 21 with AC main cable 20 and connector lines 19 to the control means 13 of the washing machine 11. In the control means 13, the signal or the information contained in the signal respectively is recognized and used for defining the functionality of the machine 11. This functionality is then stored into the electronic storage means in the control means 13.

The main advantage to be taken from the embodiment according to figure 1 is that on one hand, testing and setting up of a manufactured washing machine 11 can be done with only one connection to a setup and test device 25. This means, no further electrical connections to the control means 13 for providing the information about the machine setup need to be installed. This saves technical costs as well as time for fixing such further connections.

After having defined the functionality of the washing machine 11 by storing the information into storage means of the control means, a testing can be performed. Such a testing is performed in a usual way and as such need not be described in further detail.

## Claims

1. Method for defining a version of an electrical appliance (11) as a machine setup, wherein preferably the electrical appliance is a domestic appliance, wherein according to the wanted version of the appliance (11) an appliance is defined regarding its functionality, wherein the appliance has a control means (13), an electronic storage means and a main cable (20) for power supply, wherein in the electronic storage means the machine setup for defining the functionality is stored, wherein the appliance is connected to a setup and test device (25) by means of the main cable (20) and the information for the machine setup is being transmitted from the setup and test device via the main cable.

2. Method according to claim 1, wherein the control means (13) have a decoding of the information received through the main cable (20).

3. Method according to claim 1 or 2, wherein the information for the machine setup is transmitted by means of modulation of the information into a signal.

4. Method according to one of the preceding claims, wherein the information for the machine setup is modulated onto the voltage for powering the appliance (11), preferably by frequency modulation.

5. Method according to one of the preceding claims, wherein the information for the machine setup is modulated with different frequencies, preferably in a digital way, wherein a lower frequency and a higher frequency are being used, preferably a lower frequency having the meaning of logical 0 and a higher frequency of logical 1.

6. Method according to one of the claims 1 to 4, wherein the information for the machine setup is encoded, a certain frequency bearing the information for a certain machine setup.

7. Method according to one of the preceding claims, wherein the frequencies are being transmitted for a fixed time, the fixed time preferably being about 1 second.

8. Method according to one of the preceding claims, wherein the electronic storage means are an EEPROM.

9. Method according to one of the preceding claims, wherein the electrical appliance is a washing machine (11) or a dishwasher.

10. Method according to one of the preceding claims, wherein the information for the machine setup contains information for defining functionalities of the appliance (11) and for influencing them, preferably for defining a given model series of the appliance or defining touch control buttons (15) or programs of the control means.

11. Method according to one of the preceding claims, wherein the information for the machine setup is given in an optical identification marking (23) being assigned to the appliance (11), the optical identification marking being read and analysed and transmitted to the setup and test device (25), wherein the setup and test device produces the information for the machine setup from this optical identification marking.

12. Method according to claim 11, wherein the optical identification marking is machine or computer readable, preferably a barcode (23).

13. Method according to one of the preceding claims, wherein the appliance (11) has a display means (17) on which information according to the machine setup or according to the optical identification marking (23) is being displayed, wherein the display means are connected to the control means (13).

## Patentansprüche

1. Verfahren zum Definieren einer Version für ein elektrisches Gerät (11) als Geräteeinstellung, worin bevorzugt das elektrische Gerät ein Haushaltsgerät ist, worin gemäß der gewünschten Version des Geräts (11) ein Gerät bezüglich seiner Funktionalität definiert wird, worin das Gerät Steuermittel (13), ein elektronisches Speichermittel und ein Zufuhrkabel (20) für Energieversorgung aufweist, worin im elektronischen Speichermittel die Geräteeinstellung zum Definieren der Funktionalität gespeichert ist, worin das Gerät mit einer Aufbau- und Testeinrichtung (25) mittels des Zufuhrkabels (20) verbunden ist und die Information für die Geräteeinstellung von der Aufbau- und Testeinrichtung über das Zufuhrkabel übertragen wird.

2. Verfahren nach Anspruch 1, worin die Steuermittel (13) eine Decodierung von durch das Zufuhrkabel (20) empfangener Information aufweisen.

3. Verfahren nach Anspruch 1 oder 2, worin die Information für die Geräteeinstellung mittels Modulation der Information in ein Signal übertragen wird.

4. Verfahren nach einem der vorhergehenden Ansprüche, worin die Information für die Geräteeinstellung auf die Spannung zur Energiezufuhr des Geräts (11) moduliert wird, bevorzugt durch Frequenzmodulation.

5. Verfahren nach einem der vorhergehenden Ansprüche, worin die Information für die Geräteeinstellung mit verschiedenen Frequenzen moduliert wird, bevorzugt auf digitalem Weg, worin eine niedrigere Frequenz und eine höhere Frequenz verwendet werden, bevorzugt eine niedrigere Frequenz mit der Bedeutung einer logischen 0 und eine höhere Frequenz mit der Bedeutung einer logischen 1.

6. Verfahren nach einem der Ansprüche 1 bis 4, worin die Information für die Geräteeinstellung codiert wird, wobei eine bestimmte Frequenz die Information für eine bestimmte Geräteeinstellung trägt.

7. Verfahren nach einem der vorhergehenden Ansprüche, worin die Frequenzen über eine feste Zeitdauer übertragen werden, wobei die feste Zeitdauer bevorzugt ungefähr 1 Sekunde beträgt.

8. Verfahren nach einem der vorhergehenden Ansprüche, worin die elektronischen Speichermittel ein EEPROM sind.

9. Verfahren nach einem der vorhergehenden Ansprüche, worin das elektrische Gerät eine Waschmaschine (11) oder eine Geschirrspülmaschine ist.

10. Verfahren nach einem der vorhergehenden Ansprüche, worin die Information für die Geräteeinstellung Information zum Definieren von Funktionalitäten des Geräts (11) und zu ihrer Beeinflussung enthält, bevorzugt zum Definieren einer gegebenen Modellreihe des Geräts oder Definieren von Berührungsschaltknöpfen (15) oder Programmen der Steuermittel.

11. Verfahren nach einem der vorhergehenden Ansprüche, worin die Information für die Geräteeinstellung in einer optischen Identifizierungsmarkierung (23) gegeben wird, die dem Gerät (11) zugeordnet ist, wobei die optische Identifizierungsmarkierung gelesen und analysiert und an die Aufbau- und Testeinrichtung (25) übertragen wird, worin die Aufbau- und Testeinrichtung Information für die Geräteeinstellung aus der optischen Identifizierungsmarkierung erzeugt.

12. Verfahren nach Anspruch 11, worin die optische Identifizierungsmarkierung maschinen- oder computerlesbar ist, bevorzugt ein Barcode (23).

13. Verfahren nach einem der vorhergehenden Ansprüche, worin das Gerät (11) ein Anzeigemittel (17) aufweist, auf dem Information gemäß der Geräteeinstellung oder gemäß der optischen Identifizierungsmarkierung (23) angezeigt wird, worin die Anzeigemittel mit den Steuermitteln (13) verbunden sind.

## Revendications

1. Méthode pour définir la version d'un appareil électrique (11) tel qu'un réglage, sachant que l'appareil électrique est de préférence un appareil ménager, qu'un appareil est défini conformément à sa fonctionnalité selon la version désirée de l'appareil (11), que l'appareil présente un moyen de commande (13), un support d'enregistrement électronique et un câble principal (20) pour l'alimentation en énergie, que le réglage définissant la fonctionnalité est enregistré sur le support d'enregistrement électronique, que l'appareil est connecté à un dispositif de réglage et de contrôle (25) par l'intermédiaire du câble principal (20) et que le dispositif de réglage et de contrôle transmet les informations nécessaires au réglage via le câble principal.

2. Méthode selon la revendication 1, sachant que le panneau de commande (13) présente un décodeur pour les informations reçues via le câble principal (20).

3. Méthode selon la revendication 1 ou 2, sachant que les informations nécessaires au réglage sont transmises par modulation des informations en un signal.

4. Méthode selon l'une des revendications précédentes, sachant que les informations nécessaires au réglage sont modulées dans la tension d'alimentation de l'appareil (11), de préférence par modulation de fréquence.

5. Méthode selon l'une des revendications précédentes, sachant que les informations nécessaires au réglage sont modulées sur différentes fréquences, de préférence de façon numérique, sachant qu'une fréquence minimale et une fréquence maximale sont utilisées, de préférence une fréquence minimale correspondant à l'état logique 0 et une fréquence maximale correspondant à l'état logique 1.

6. Méthode selon l'une des revendications 1 à 4, sachant que les informations nécessaires au réglage sont encodées, un certain fréquence renfermant les informations pour un certain réglage.

7. Méthode selon l'une des revendications précédentes, sachant que les fréquences sont transmises sur une durée fixe étant de préférence d'environ 1 seconde.

8. Méthode selon l'une des revendications précédentes, sachant que le support d'enregistrement électronique est une EEPROM.

9. Méthode selon l'une des revendications précédentes, sachant que l'appareil électrique est un lave-linge (11) ou un lave-vaisselle.

10. Méthode selon l'une des revendications précédentes, sachant que les informations nécessaires au réglage contiennent des informations permettant de définir les fonctionnalités de l'appareil (11) et de les influencer, de préférence pour définir une série de modèles donnés de l'appareil ou définir les touches de commande (15) ou les programmes du moyen de commande.

11. Méthode selon l'une des revendications précédentes, sachant que les informations nécessaires au réglage sont portées sur un marquage optique d'identification (23) appliqué sur l'appareil (11), le marquage optique d'identification étant lu, analysé et transmis au dispositif de réglage et de contrôle (25), sachant que le dispositif de réglage et de contrôle produit les informations nécessaires au réglage à partir du marquage optique d'identification.

12. Méthode selon la revendication 11, sachant que le marquage optique d'identification peut être lu par un appareil ou un ordinateur et qu'il s'agit de préférence d'un code-barres (23).

13. Méthode selon une des revendications précédentes, sachant que l'appareil (11) présente un écran (17) sur lequel s'affichent les informations en fonction du réglage ou du marquage optique d'identification (23), l'écran étant connecté au panneau de commande (13).
